# EUROPÄISCHE PATENTSCHRIFT

(11) **EP 3 303 081 B1**
(45) Veröffentlichungstag und Bekanntmachung des Hinweises auf die Patenterteilung: **03.04.2019**
(21) Anmeldenummer: 16720746.3
(22) Anmeldetag: 19.04.2016
(51) Int. Cl.: B60T 13/57, B60T 13/52, B60T 13/74

(54) **EINRICHTUNG ZUM VARIIEREN EINES PEDALWIDERSTANDS, BREMSSYSTEM**
DEVICE FOR VARYING A PEDAL RESISTANCE, BRAKE SYSTEM
DISPOSITIF POUR FAIRE VARIER LA RÉSISTANCE D'UNE PÉDALE, SYSTÈME DE FREINAGE

(30) Priorität: 27.05.2015 DE 102015209732
(43) Veröffentlichungstag der Anmeldung: 11.04.2018
(73) Patentinhaber: Robert Bosch GmbH, 70442 Stuttgart (DE)
(72) Erfinder: FRIEDRICH, Thomas, 74379 Ingersheim (DE); TRAUTMANN, Simon, 70599 Stuttgart (DE)
(86) Internationale Anmeldenummer: PCT/EP2016/058618
(87) Internationale Veröffentlichungsnummer: WO 2016/188674

(56) Entgegenhaltungen:
- EP-A1- 1 571 062
- WO-A1-2009/086923
- DE-A1-102008 041 403
- DE-A1-102012 205 432
- DE-A1-102014 214 644
- KR-B1- 100 916 410
- US-A1- 2003 006 669

## Beschreibung

Die Erfindung betrifft eine Einrichtung zum Variieren eines Pedalwiderstands eines hydraulischen Bremssystems, mit wenigstens einem ersten elektroaktiven Polymeraktuator.

Ferner betrifft die Erfindung ein Bremssystem für ein Fahrzeug, insbesondere Kraftfahrzeug, mit einem Hauptbremszylinder, mit einem Bremspedal zur Verlagerung eines Kolbens in dem Hauptbremszylinder, mit einem Bremskraftverstärker und mit einer Einrichtung zum Variieren eines Pedalwiderstands des Bremspedals.

Weiterhin betrifft die Erfindung ein Verfahren zum Betreiben der Einrichtung oder des Bremssystems.

### Stand der Technik

In hydraulischen Bremssystemen von Kraftfahrzeugen wird meist ein Bremspedal durch den Fahrer betätigt, wobei das Bremspedal einen Kolben in einem Hauptbremszylinder häufig mit Unterstützung eines Bremskraftverstärkers verschiebt, wobei an den Ausgängen des Hauptbremszylinders ein Hydraulikaggregat, wie beispielsweise ein ESP- oder ABS-Aggregat angeschlossen ist. Dadurch wird Bremsflüssigkeit in das Hydraulikaggregat eingebracht und zu den Radbremszylindern geleitet. Dort erhöht das eingebrachte Volumen den Bremsdruck und führt durch Anpressen der Bremsbeläge an die Bremsscheiben zu einer Bremswirkung. Bekannt sind unterschiedliche Ausgestaltungen von Bremskraftverstärkern, beispielsweise pneumatische, hydraulische oder auch elektromechanische Bremskraftverstärker.

Aus der Offenlegungsschrift DE 11 2007 000 961 D5 ist es außerdem bereits bekannt, dass ein Pedalwiderstand durch einen Polymeraktuator variierbar ist.

Aus der EP 1 571 062 A1 ist ferner die Verwendung eines piezoelektrischen Aktuators und aus der KR 1 009 164 10 B1 die Verwendung eines EAP (Elektro-Aktives-Polymer) zum Zweck der Kontrolle des Pedalwiderstandes bekannt.

### Offenbarung der Erfindung

Die erfindungsgemäße Einrichtung mit den Merkmalen des Anspruchs 1, das erfindungsgemäße Bremssystem mit den Merkmalen des Anspruchs 8 sowie das erfindungsgemäße Verfahren mit den Merkmalen des Anspruchs 11 haben den Vorteil, dass die Integration des Polymeraktuators in das Bremssystem besonders einfach und bauraumsparend erfolgt beziehungsweise erfolgen kann, und dass der Bremspedalwiderstand in Abhängigkeit von unterschiedlichen Betriebszuständen vorteilhaft anpassbar ist. Die erfindungsgemäße Einrichtung zeichnet sich dabei dadurch aus, dass sie eine Reaktionsscheibe aufweist, die mindestens zwei unabhängig voneinander ansteuerbare Polymeraktuatoren aufweist, welche koaxial zueinander angeordnet sind. Der Polymeraktuator ist also zusammen mit einem weiteren Polymeraktuator Bestandteil einer Reaktionsscheibe geworden. Hydraulische Bremssysteme weisen regelmäßig eine Reaktionsscheibe auf, die zwischen dem Pedal und dem zu verschiebenden Kolben geschaltet ist. Üblicherweise bestehen Reaktionsscheiben aus einem Kunststoff, insbesondere Elastomer, und sind durch Einwirkung aus Pedalkraft und/oder Bremsverstärkerkraft verformbar. Dabei ist das Material herkömmlicher Reaktionsscheiben nicht komprimierbar und wird sowohl bei Vakuumbremskraftverstärkern als auch bei elektromechanischen Bremskraftverstärken eingesetzt. Für das Pedalgefühl, insbesondere den Pedalwiderstand, ist sie maßgeblich. Dadurch, dass vorliegend die Reaktionsscheibe zwei Polymeraktuatoren umfasst, lässt sich die Eigenschaft der Reaktionsscheibe im Betrieb auf einfache Art und Weise verändern, sodass das Pedalgefühl, insbesondere der Pedalwiderstand entsprechend variiert wird. Da die Reaktionsscheibe ohnehin meistens vorhanden ist, ist ein Austausch mit der erfindungsgemäßen Einrichtung ohne weiteres möglich und führt zu den oben bereits genannten Vorteilen. Dadurch, dass die Polymeraktuatoren koaxial zueinander angeordnet sind, wirken sie über ihren Umfang gesehen gleichmäßig zwischen dem Bremspedal und dem Kolben. Selbstverständlich sind dabei Kolben und Bremspedal nicht unbedingt direkt an der Reaktionsscheibe anliegend, vielmehr ist bevorzugt vorgesehen, dass das Bremspedal durch eine Bremspedalstange auf die Reaktionsscheibe wirkt und dass die Reaktionsscheibe auf den Kolben des Hauptbremszylinders durch eine Kolbenstange wirkt beziehungsweise die durch Bremspedal und/oder Bremskraftverstärker eingeleitete Kraft weiterleitet. Bevorzugt ist die Reaktionsscheibe in ihrem Außenumfang begrenzt, sodass unabhängig von einer Bestromung/Ansteuerung der Polymeraktuatoren die Reaktionsscheibe nur einen maximal vorgebbaren Außendurchmesser beziehungsweise Außenumfang aufweisen kann. Das bedeutet, dass eine Ausdehnung der Reaktionsscheibe in radialer Richtung nur bis zu einem vorgegebenen Maß möglich ist. Dies hat zur Folge, dass dann, wenn einer der Polymeraktuatoren bestromt wird, sich dieser zusammenzieht und dadurch Elastomermaterial radial nach außen oder innen drängt, der andere Polymeraktuator, wenn er nicht angesteuert/bestromt wird, nicht ebenfalls nach außen beziehungsweise nach innen gedrängt wird, sondern radial gestaucht und dadurch axial gestreckt wird. Diese Begrenzung des Außenumfangs kann beispielsweise durch eine feste Mantelwand oder Hülse, in welcher die Polymeraktuatoren angeordnet sind, gewährleistet werden.

Gemäß einer bevorzugten Weiterbildung der Erfindung ist vorgesehen, dass die Polymeraktuatoren getrennt voneinander ausgebildet sind. Damit sind die Polymeraktuatoren getrennt voneinander herstellbar und montierbar, was zu einer kostengünstigen Fertigung führen kann. Vorzugsweise werden die getrennten Polymeraktuatoren auf einem gemeinsamen Tragelement angeordnet und befestigt, wobei das Tragelement insbesondere als Anlageelement für das Bremspedal beziehungsweise die Pedalstand des Bremspedals und/oder für den Kolben beziehungsweise die Kolbenstange dient.

Gemäß einer bevorzugten Weiterbildung der Erfindung ist vorgesehen, dass die Polymeraktuatoren wenigstens eine gemeinsame, dielektrische Elastomerschicht aufweisen. Die Polymeraktuatoren sind somit nicht getrennt ausgebildet, sondern weisen gemeinsame Funktionselemente, insbesondere eine gemeinsame Elastomerschicht auf. Hierdurch wird eine besonders kompakte Ausbildung der Reaktionsscheibe geboten. Darüber hinaus ist das Zusammenspiel des inneren Polymeraktuators mit dem äußeren Polymeraktuator oder andersherum aufgrund der gemeinsamen Elastomerschicht verbessert. Wird beispielsweise der innenliegende Polymeraktuator angesteuert, sodass er in axialer Richtung gestaucht wird, so dehnt er sich radial aus. Durch die gemeinsame Elastomerfläche wird dadurch der außenliegende Polymeraktuator direkt mit einer Kraft beaufschlagt. Entsprechend wirken sich auch Bewegungen des außenliegenden Polymeraktuators auf den innenliegenden Polymeraktuator aus. Insbesondere ist vorgesehen, dass die Polymeraktuatoren mehrere gemeinsame Elastomerschichten aufweisen. Besonders bevorzugt ist vorgesehen, dass alle Elastomerschichten sowohl dem innenliegenden als auch dem außenliegenden Polymeraktuator zugeordnet sind. Es sei darauf hingewiesen, dass der außenliegende Polymeraktuator bevorzugt ringförmige, insbesondere kreisringförmige Elektroden aufweist. Alternativ kann jedoch auch vorgesehen sein, dass der außenliegende Polymeraktuator mehrere ringsegmentförmige, insbesondere kreisringsegmentförmige Elektroden aufweist, die um den innenliegenden Polymeraktuator herum angeordnet sind.

Gemäß einer bevorzugten Weiterbildung der Erfindung ist vorgesehen, dass wenigstens eine Elektrode der Polymeraktuatoren, insbesondere jedes Polymeraktuators, zumindest bereichsweise seitlich zur elektrischen Kontaktierung vorsteht. Die wenigstens eine Elektrode steht somit vor, sodass sie einfach elektrisch kontaktiert werden kann. Insbesondere ist vorgesehen, dass benachbarte Elektroden in unterschiedliche Richtungen vorstehen, wobei besonders bevorzugt vorgesehen ist, dass mehrere Elektroden eines Polymeraktuators abwechselnd in eine und in eine andere Richtung vorstehen, sodass eine einfache Kontaktierung jeder zweiten Elektrode möglich ist.

Weiterhin ist bevorzugt vorgesehen, dass die Polymeraktuatoren gemeinsam eingehaust sind, wobei die Einhausung verformbar ausgebildet ist, sodass die Ansteuerung der Polymeraktuatoren zu einer entsprechenden Verformung der Einhausung führt, die sich auf den Betrieb des Bremssystems beziehungsweise der Reaktionsscheibe entsprechend auswirkt. Dabei kann beispielsweise vorgesehen sein, dass die Einhausung elastisch verformbare Stirnflächen aufweist.

Gemäß einer alternativen Ausführungsform der Erfindung ist bevorzugt vorgesehen, dass die Einhausung insgesamt elastisch verformbar ausgebildet ist. Dadurch wird eine einfache und besonders variable Veränderung der Form der Reaktionsscheibe und damit eine entsprechende Variierung des Bremspedalwiderstands gewährleistet. Alternativ ist bevorzugt vorgesehen, dass zumindest die Mantelaußenwand der Einhausung aus einem festen, insbesondere elastisch nicht verformbaren Material gefertigt ist, um die zuvor beschriebene Begrenzung des Außenumfangs beziehungsweise Außendurchmessers der Reaktionsscheibe zu begrenzen.

Besonders bevorzugt ist die Einhausung aus dem Material der gemeinsamen Elastomerschicht gefertigt. Insbesondere ist vorgesehen, dass das Material der Elastomerschicht nicht nur zwischen den Elektroden liegt, sondern die Elektroden auch radial und stirnseitig umfasst, sodass die Polymeraktuatoren insgesamt durch das Material der Elastomerschicht eingehaust sind. Hierdurch ergibt sich eine besonders kompakte und einfach zu handhabende Einheit.

Das erfindungsgemäße Bremssystem zeichnet sich durch die erfindungsgemäße Einrichtung aus. Es ergeben sich hierdurch die bereits genannten Vorteile. Weitere Merkmale und Vorteile ergeben sich aus dem zuvor Beschriebenen sowie aus den Unteransprüchen.

Insbesondere ist vorgesehen, dass die Reaktionsscheibe zwischen einem durch das Bremspedal verschiebbaren Bremskolben und einem durch den Bremskraftverstärker verschiebbaren Verstärkerkolben einerseits und dem Kolben des Hauptbremszylinders andererseits geschaltet beziehungsweise angeordnet ist, wobei der innenliegende Polymeraktuator der Reaktionsscheibe einen Durchmesser aufweist, der kleiner oder gleich dem Durchmesser des Bremskolbens ist, sodass sich eine Ansteuerung des innenliegenden Polymeraktuators zunächst nur auf die Betätigung des Bremskolbens durch das Bremspedal auswirkt. Dabei ist vorgesehen, dass der Bremskolben und der Verstärkerkolben zweckmäßigerweise ebenfalls koaxial zueinander angeordnet sind, wobei der Bremskolben innen und der Verstärkerkolben außen in der Art einer Zylinderhülse angeordnet ist. Bevorzugt entspricht der Außendurchmesser des Verstärkerkolbens zumindest im Wesentlichen dem Außendurchmesser der Reaktionsscheibe, sodass der Verstärkerkolben insbesondere mit dem Bereich der Reaktionsscheibe zusammenwirkt, in welchem der außenliegende Polymeraktuator angeordnet ist, sodass durch eine Ansteuerung des außenliegenden Polymeraktuators das Bremsverhalten bei einer Betätigung des Bremskraftverstärkers beeinflussbar ist. Gemäß einer bevorzugten Weiterbildung der Erfindung ist vorgesehen, dass die zuvor beschriebene Begrenzung des Außenumfangs der Reaktionsscheibe durch den Verstärkerkolben und/oder den Kolben des Hauptbremszylinders gebildet wird, wobei der Verstärkerkolben oder der Kolben des Hauptbremszylinders dazu jeweils eine axiale Aufnahmevertiefung aufweisen, in welche die Reaktionsscheibe einlegbar ist, und welche einen Innendurchmesser aufweist, die dem maximal erlaubten Außendurchmesser der Reaktionsscheibe entspricht

Weiterhin ist bevorzugt vorgesehen, dass wenigstens einer der Polymeraktuatoren als Stapelaktuator und/oder dass wenigstens einer der Polymeraktuatoren als Rollenaktuator ausgebildet ist. Insbesondere sind die beiden Polymeraktuatoren der Reaktionsscheibe jeweils gleich ausgebildet, sodass beide Polymeraktuatoren entweder Stapelaktuatoren oder Rollenaktuatoren sind.

Das erfindungsgemäße Verfahren mit den Merkmalen des Anspruchs 11 zeichnet sich dadurch aus, dass die Polymeraktuatoren der Reaktionsscheibe unabhängig voneinander in Abhängigkeit eines gewünschten Pedalwiderstands angesteuert werden. insbesondere ist vorgesehen, dass in Abhängigkeit des gewünschten Pedalwiderstands nur der innenliegende Polymeraktuator, nur der außenliegende Polymeraktuator oder beide Polymeraktuatoren bestromt beziehungsweise angesteuert werden. Weitere Merkmale und Vorteile des Verfahrens ergeben sich aus dem zuvor Beschriebenen sowie aus den Ansprüchen.

Im Folgenden soll die Erfindung anhand der Zeichnung näher erläutert werden. Dazu zeigen
- Figur 1: eine vereinfachte Schnittdarstellung eines Bremssystems,
- Figur 2: eine vereinfachte Schnittdarstellung einer Reaktionsscheibe des Bremssystems,
- Figur 3: eine vereinfachte Draufsicht auf die Reaktionsscheibe,
- Figuren 4A bis 4C: unterschiedliche Betriebszustände des Bremssystems,
- Figur 5: ein weiteres Ausführungsbeispiel der Reaktionsscheibe und
- Figur 6: eine Charakteristik des Bremssystems.

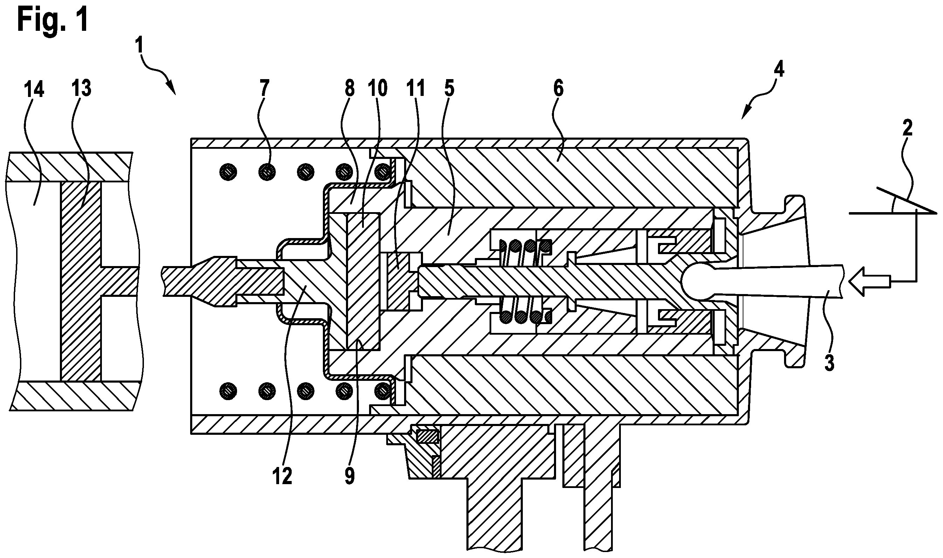

Figur 1 zeigt in einer vereinfachten Schnittdarstellung ein Bremssystem 1 eines hier nicht näher dargestellten Kraftfahrzeugs. Das Bremssystem 1 weist ein Bremspedal 2 auf, das hier nur schematisch gezeigt ist, das mechanisch mit einem Bremskolben 3 verbunden ist, der längsverschieblich in einem Bremskraftverstärker gelagert ist. Der Bremskraftverstärker 4 weist einen koaxial zu dem Bremskolben 3 angeordneten und parallel dazu verlagerbaren Verstärkerkolben 5 auf, der durch einen Aktuator 6 entgegen der Kraft eines Federelements 7 verlagerbar ist. Der Verstärkerkolben 5 weist an seinem freien Ende 8 eine axiale Aufnahmevertiefung 9 auf, in welcher eine Reaktionsscheibe 10 angeordnet ist. Die Reaktionsscheibe 10 ist dabei koaxial zu dem Verstärkerkolben 5 ausgerichtet. In die Aufnahmevertiefung 9 mündet auch eine Aussparung 11, in welcher der Bremskolben 3 verlagerbar geführt ist, sodass, der Bremskolben 3, wenn er durch das Bremspedal 2 betätigt wird, in Richtung der Reaktionsscheibe 10 verschoben wird, bis er auf diese trifft.

Auf der dem Verstärkerkolben 9 und dem Bremskolben 3 abgewandten Seite liegt die Reaktionsscheibe 10 an einer Kolbenstange 12 eines Kolbens 13 an, welcher in einem Hauptbremszylinder 14 des Bremssystems 1 zum Erzeugen eines hydraulischen Drucks verlagerbar ist. Der Kolben 13 kann somit durch Bremspedalbetätigung und/oder durch Aktivierung des Aktuators 6 betätigt werden. Bei einer herkömmlichen Ausbildung der Reaktionsscheibe 10 wäre diese aus einem Elastomer gefertigt, der einen Pedalwiderstand bei der Betätigung mit dem Bremspedal erzeugt, der für den Betrieb des Bremssystems 1 typisch und vom Fahrer haptisch erfassbar ist.

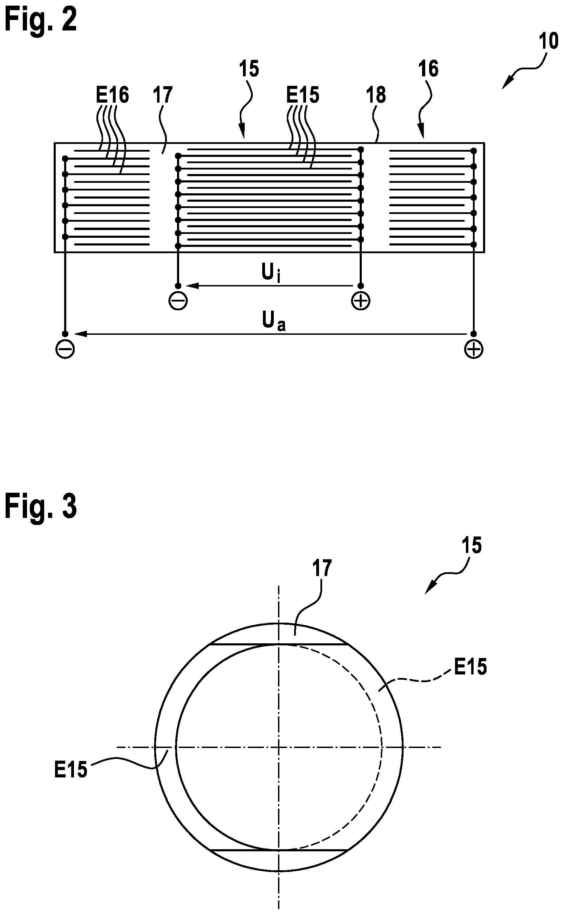

Vorliegend ist jedoch gemäß Figur 2, die die Reaktionsscheibe 10 in einer Schnittdarstellung zeigt, vorgesehen, dass die Reaktionsscheibe 10 zwei Polymeraktuatoren 15 und 16 aufweist, die koaxial zueinander und zu dem Verstärkerkolben 5 angeordnet sind. Dabei ist der außenliegende Polymeraktuator 16 ringförmig, insbesondere kreisringförmig ausgebildet, sodass er den innenliegenden Polymeraktuator 15 umfangsseitig umschließt. Der Außendurchmesser des Polymeraktuators 15 entspricht im Wesentlichen dem Außendurchmesser des Verstärkerkolbens 5 an der axialen Anlagefläche für die Reaktionsscheibe 10. Die beiden Polymeraktuatoren 15 und 16 können unabhängig voneinander angesteuert beziehungsweise bestromt werden. Beide Polymeraktuatoren 15, 16 weisen jeweils mehrere Elektroden E15 beziehungsweise E16 auf, zwischen denen jeweils ein dielektrisches Elastomer angeordnet ist. Werden die Elektroden E15, E16 des jeweiligen Polymeraktuators 15 oder 16 bestromt beziehungsweise mit einer elektrischen Spannung beaufschlagt, so ziehen sich die Elektroden E15 oder E16 des jeweiligen Polymeraktuators 15, 16 gegenseitig an, wodurch das dazwischenliegende Elastomer gestaucht wird. Weil das Elastomer nichtkompressibel ausgebildet ist, führt das Stauchen zu einer Flächenvergrößerung senkrecht zur Stauchrichtung. Vorliegend ist vorgesehen, dass das zwischen den Elektroden E15 und E16 vorgesehene Elastomer 17 als gemeinsames Elastomer der Polymeraktuatoren 15 und 16 ausgebildet ist, sodass sich die Elastomerschichten durch beide Polymeraktuatoren 15, 16 hindurchziehen und insbesondere auch eine Einhausung 18 der Polymeraktuatoren 15, 16 und damit der Reaktionsscheibe 10 bilden. Die Reaktionsscheibe 10 stellt somit eine einzige monolithische Reaktionsscheibe 10 mit darin integrierten Polymeraktuatoren 15, 16 dar. Alternativ zu der gezeigten Ausführungsform kann auch vorgesehen sein, dass die Reaktionsscheibe 10 aus zwei oder mehreren voneinander getrennt ausgebildeten Polymeraktuatoren 15, 16 gebildet wird, die zusammen verklebt oder voneinander getrennt ausgebildet/angeordnet sind.

Figur 3 zeigt anhand einer vereinfachten Draufsicht auf den Polymeraktuator 15, wie die Elektroden E15, E16 der beiden Polymeraktuatoren elektrische kontaktiert werden können. Dazu ist vorliegend vorgesehen, dass die Elektroden E15 bereichsweise seitlich vorstehen. Dabei ist besonders vorgesehen, dass die benachbarten Elektroden an unterschiedlichen Seiten des Polymeraktuators 15 abwechselnd vorstehen, sodass jede zweite Elektrode auf einer Seite des Polymeraktuators und jede dazwischenliegende weitere Elektrode desselben Polymeraktuators auf der gegenüberliegenden Seite elektrisch kontaktiert werden können. Dadurch können die einzelnen Elektroden abwechselnd mit negativen und mit positivem Spannungspotential kontaktiert werden. Die Elektroden müssen dabei nicht unbedingt auf gegenüberliegenden Seiten vorstehen, vielmehr können sie auch benachbart zueinander, in der Draufsicht gesehen, vorstehen.

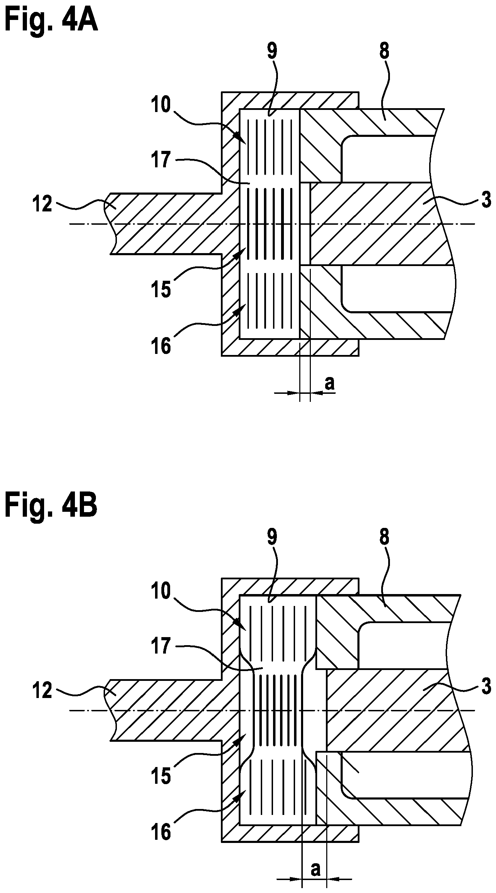

Figuren 4A bis 4C zeigen die vorteilhafte Reaktionsscheibe 10 im verbauten Zustand im Bremssystem 1, jeweils in einer vereinfachten Darstellung.

Gemäß Figur 4A sind die Polymeraktuatoren 15 und 16 nicht aktiviert/bestromt beziehungsweise nicht mit einer elektrischen Spannung beaufschlagt. Die Reaktionsscheibe 10 befindet sich in diesem Fall in ihrem neutralen Zustand.

Wird nur der innenliegende Polymeraktuator 15 bestromt, wie in Figur 4B gezeigt, staucht sich dieser zusammen. Aufgrund der Volumenkonstanz dehnt sich die Reaktionsscheibe 10 in dem Bereich, der nicht unter Spannung ist, aus. Diese Ausdehnung ist nur in Form einer Dickenänderung, also in einer Ausdehnung in axialer Richtung im Bereich des außenliegenden Polymeraktuators 16 möglich, da sich die Reaktionsscheibe 10 einen Außendurchmesser aufweist, der dem Innendurchmesser der Aufnahme 9 entspricht, sodass sie sich in der Aufnahmevertiefung 9 nicht radial ausdehnen kann.

Dabei ist in Figur 4B klar zu erkennen, dass sich ein Weg a zwischen Bremskolben und Reaktionsscheibe 10 gegenüber dem Ursprungszustand gemäß Figur 4A vergrößert hat. Tritt der Fahrer nun auf das Bremspedal 2, so ist der Weg a, bei dem das Bremssystem 1 nahezu keine Gegenkraft auf das Bremspedal 2 aufbaut aber trotzdem eine Bremswirkung durch den Bremskraftverstärker erzeugt wird, wenn gleichzeitig der Aktuator 6 angesteuert wird, groß. Hier ist der sogenannte Jump-in-Bereich groß, das heißt es wird eine stärkere Bremswirkung erzielt, ohne dass eine entsprechende Gegenkraft am Pedal, also ein entsprechender Pedalwiderstand spürbar ist. Der Fahrer würde das als "giftige Bremse" definierten beziehungsweise erleben. Der Weg a zusammen mit dem Jump-in-Weg des Bremssystems 1 ist groß, wird aber im Normalbetrieb vom Fahrer aufgrund der "Giftigkeit" des Bremssystems 1 nicht wahrgenommen.

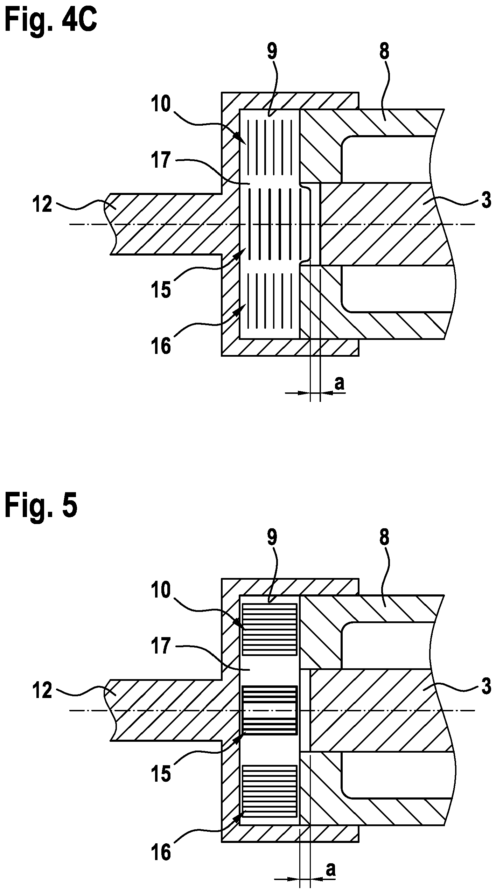

Figur 4C zeigt ein Betriebszustand, bei welchem nur der außenliegende Polymeraktuator 16 unter Spannung gesetzt wird. Dadurch staucht sich der außenliegende Polymeraktuator 16 axial zusammen. Die Reaktionsscheibe 10 muss sich in dem Bereich, der nicht unter Spannung ist, also im Bereich des inneren Polymeraktuators 15, ausdehnen. Auch hier gilt für das Elastomer 17, dass es sich nur dahin ausdehnen kann, wo es noch Platzt gibt, nämlich in axial in der Mitte, also in Richtung des Bremskolbens 3, wie in Figur 4C gezeigt. Der Außendurchmesser des innenliegenden Polymeraktuators 15 ist kleiner gewählt, als der Außendurchmesser des Kolbens 3 in der Aussparung 11, sodass sich der Polymeraktuator 15 bereichsweise in die Aussparung 11 hinein verformen kann, wie in Figur 4C gezeigt.

Dadurch wird der Weg a zwischen Bremskolben 3 und Reaktionsscheibe 10 deutlich verringert. Tritt der Fahrer nun auf das Bremspedal 2 ist der Weg a sehr schnell überwunden und das Bremssystem 1 kann mittels der Reaktionsscheibe 10 eine Gegenkraft auf das Bremspedal aufbauen, während der Bremskraftverstärker 4 eine Bremswirkung erzeugt. Hier ist der Jump-in kleiner, das heiß ungefähr bei Einsetzen der Bremswirkung tritt auch ein entsprechender Pedalwiderstand auf. Der Fahrer würde dies als "lineare Bremse" definieren oder erleben, die sehr leicht zu dosieren ist. Der Weg a zusammen mit dem Jump-in-Weg des Bremssystems 1 ist dabei gering.

Selbstverständlich können auch sowohl der innere als auch der äußere Polymeraktuator 15, 15 gleichzeitig unter elektrische Spannung gesetzt werden, hierdurch ändert sich jedoch die Form der Reaktionsscheibe 10 nicht. Ohne mechanische Randbedingungen würde sich die Reaktionsscheibe 10 in etwa gleichmäßig stauch und sich dabei im Durchmesser vergrößern. Im eingebauten Zustand, also in der Aufnahme 9 des Verstärkerkolbens 8, ist dies aufgrund der Dimensionierung des Außendurchmessers der Reaktionsscheibe 10 und des Innendurchmessers der Aufnahmevertiefung 9 nicht möglich. Folglich kann sich die Reaktionsscheibe 10 auch nicht stauchen.

Alternativ zu den in den oben beschriebenen Ausführungsbeispiel vorgestellten Ausbildungen der Polymeraktuatoren 15, 16 als Stapelaktuatoren ist es auch denkbar, einen oder beide Polymeraktuatoren als Rollenaktuatoren auszubilden, wie beispielhaft in Figur 5 gezeigt. Die aktive Reaktionsscheibe 10 besteht in diesem Fall, wie in Figur 5 gezeigt, aus zwei konzentrisch zueinander angeordneten Rollenaktuatoren: Der äußere Polymeraktuator 16, der auf den Verstärkerkolben 8 wirkt, und der innere Polymeraktuator 15, der auf den Bremskolben 3 wirkt. Die Funktionsweise mit der Veränderung des Spiels beziehungsweise des Wegs a ist dieselbe wie im oben stehend beschriebenen Beispiel. Es können auch andere Anordnungen gewählt werden, wie zum Beispiel ein innenliegender Rollenaktuator für den Bremskolben 3 und mehrere Rollenaktuatoren der gleichen Größe, ringförmig um den innenliegenden Rollenaktuator herum verteilt für den Verstärkerkolben 8. Wichtig ist dabei, dass die Aktuatoren, gegen den Bremskolben 3 und den Verstärkerkolben 8 unabhängig voneinander angesteuert werden können.

Während in Figur 1 gezeigt ist, dass die Reaktionsscheibe 10 radial von dem Verstärkerkolben 8 umfasst wird, ist es gemäß den Ausführungsbeispielen von Figur 4A bis 4C und Figur 5 auch möglich, die Reaktionsscheibe 10 radial durch die Kolbenstange 12 zu umfassen, sodass die axiale Aufnahmevertiefung 9 in dem Kolben 13 beziehungsweise in der Kolbenstange 12 ausgebildet ist.

Bezüglich des Aufbaus der aktiven Reaktionsscheibe 10 ergeben sich mehrere Möglichkeiten: Gemäß einem ersten Ausführungsbeispiel besteht die Reaktionsscheibe aus einem Stück, das bedeutet, dass der innere und der äußere Polymeraktuator 15, 16 miteinander insbesondere durch das Elastomermaterial 17 verklebt sind. Das Elastomermaterial 17, das sich dann zwischen und rund um den inneren und den äußeren Polymeraktuator 15, 16 befindet, kann das gleiche sein, wie das Dielektrikum, das sich zwischen den einzelnen Elektroden E15, E16 befindet, oder auch ein anderes. Alternativ kann die Reaktionsscheibe 10 auch durch zwei voneinander getrennt ausgebildete Polymeraktuatoren dargestellt werden. In dem Bremssystem 1, wenn die Polymeraktuatoren 15, 16 entsprechend in der Aufnahme 9 angeordnet werden, werden diese beiden wieder zusammengeführt.

Die Reaktionsscheib 10 beeinflusst das Bremssystem 1 durch Veränderung des Jump-in-Bereichs, also wie schnell der Weg a aufgebraucht wird. Bevor der Weg a überwunden wird, muss ein Leerweg überwunden werden. Nach dem Überwinden des Leerwegs ist eine mechanische Kopplung des Bremssystems 1 vorhanden, das heißt, dass der Weg a aufgebraucht ist und eine Bremskraft von dem Bremskolben 3 beziehungsweise dem Verstärkerkolben 8 auf den Kolben 12 übertragen werden kann.

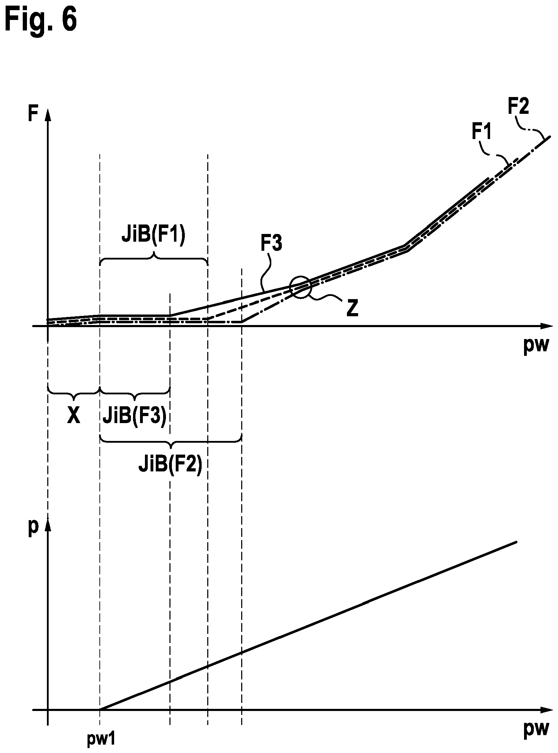

Figur 6 zeigt in einem Diagramm aufgetragen über den Pedalweg pw den Bremsdruck p und die Pedalkraft F. Eingetragen sind weiterhin der Leeweg x sowie das Verhalten der Pedalkraft F bei einer herkömmlichen Reaktionsscheibe, gezeigt durch eine gestrichelte Linie F1, im Vergleich zu der Pedalkraft F2 bei einem großen Weg a und die Pedalkraft F3 bei einem kleinen Weg a.

Nachdem der Leerweg x überwunden wurde, entstehen je nach Größe des Spiels beziehungsweise Wegs a, das wie zuvor beschrieben von der Reaktionsscheibe 10 beeinflussbar beziehungsweise variierbar ist, unterschiedliche Kraft-Weg-Kennlinien F1 und F2. Auch nach Ende des Jump-in-Bereichs JiB wird die Pedalcharakteristik durch die vorteilhafte Ausbildung der Reaktionsscheibe 10 beeinflusst, wie beispielsweise zum Punkt Z gezeigt. Der Bremsdruckaufbau, also die Verzögerung des Fahrzeugs erfolgt bereits ab Beginn des Jump-in-Bereichs JiB, wenn der Verstärkerkörper 8 auf die Reaktionsscheibe 10 drückt bei einem Bremsweg pw₁ und der Leerweg x überwunden wurde.

Zu bemerken ist, dass ab einer gewissen Bremskraft, die Wirkung der aktiv verformten Reaktionsscheibe 10 vernachlässigbar wirkt. Ab einer gewissen Bremskraft herrscht auf die Reaktionsscheibe 10 eine höhere Kraft, als die, die durch die Polymeraktuatoren 15, 16 erzeugt wird. Das bedeutet, dass der Fahrer und der Bremskraftverstärker 4 die voreingestellte Geometrie der Reaktionsscheibe 10 überdrücken kann, bis sie das Pedalgefühl nicht mehr beeinflusst. Dieser Punkt ist mit Z in Figur 6 markiert.

Durch die vorteilhafte Ausbildung kann außerdem die Funktion "Bremsscheiben-Wischfunktion" unterstützt werden, indem ohne Betätigung des Bremspedals 2 die aktive Reaktionsscheibe 10 elektrisch derart verformt wird, dass der äußere Polymeraktuator 16 axial zunimmt beziehungsweise dicker wird, sodass zwischen dem Verstärkerkolben 8 und der Kolbenstange 12 ein geringer Druck aufgebaut werden kann, der gerade dazu ausreicht, die Bremsbeläge von an den Hauptbremszylinder angeschlossenen Radbremsen an die Bremsscheiben anzulegen, um beispielsweise einen Wasserfilm von den Bremsscheiben zu entfernen. Bei leichten ACC-Bremsungen kann durch gezielte Aktivierung der Reaktionsscheibe 10 außerdem die Bremswirkung leicht verändert beziehungsweise beeinflusst werden, beispielsweise durch eine entgegengesetzte Aktivierung.

## Patentansprüche

1. Einrichtung zum Variieren eines Pedalwiderstands eines hydraulischen Bremssystems (1), mit wenigstens einem elektroaktiven Polymeraktuator (15,16), **gekennzeichnet durch** eine Reaktionsscheibe (10), die mindestens zwei unabhängig voneinander ansteuerbare Polymeraktuatoren (15,16) aufweist, welche koaxial zueinander angeordnet sind.

2. Einrichtung nach Anspruch 1, **dadurch gekennzeichnet, dass** die Polymeraktuatoren (15,16) getrennt voneinander ausgebildet sind.

3. Einrichtung nach einem der vorhergehenden Ansprüchen, **dadurch gekennzeichnet, dass** die Polymeraktuatoren (15,16) wenigstens eine gemeinsame dielektrische Elastomerschicht (17) aufweisen.

4. Einrichtung nach einem der vorhergehenden Ansprüchen, **dadurch gekennzeichnet, dass** wenigstens eine Elektrode (E15,E16) der Polymeraktuatoren (15,16) seitlich zur elektrischen Kontaktierung vorsteht.

5. Einrichtung nach einem der vorhergehenden Ansprüchen, **dadurch gekennzeichnet, dass** die Polymeraktuatoren (15,16) gemeinsam eingehaust sind, wobei die Einhausung zumindest bereichsweise verformbar ausgebildet ist.

6. Einrichtung nach einem der vorhergehenden Ansprüchen, **dadurch gekennzeichnet, dass** die Einhausung elastisch verformbar ausgebildet ist.

7. Einrichtung nach einem der vorhergehenden Ansprüchen, **dadurch gekennzeichnet, dass** die Einhausung aus dem Material der gemeinsamen Elastomerschicht (17) gefertigt ist.

8. Bremssystem (1) für ein Fahrzeug, insbesondere Kraftfahrzeug, mit einem Hauptbremszylinder (14), mit einem Bremspedal (2) zur Verlagerung eines Kolbens (13) in dem Hauptbremszylinder (14), mit einem Bremskraftverstärker (4) und mit einer Einrichtung zum Variieren eines Pedalwiderstands des Bremspedals (2), **gekennzeichnet durch** die Ausbildung der Einrichtung nach einem der Ansprüche 1 bis 7.

9. Bremssystem nach Anspruch 8, **dadurch gekennzeichnet, dass** die Reaktionsscheibe (10) zwischen einem durch das Bremspedal (2) verschiebbaren Bremskolben (3) und einem durch den Bremskraftverstärker (4) verschiebbaren Verstärkerkolben (8) einerseits und dem Kolben (13) des Hauptbremszylinders (14) andererseits geschaltet/angeordnet ist, wobei der innenliegende Polymeraktuator (15) einen Durchmesser kleiner oder gleich dem Durchmesser des Bremskolbens (3) aufweist.

10. Bremssystem nach einem der vorhergehenden Ansprüche, **dadurch gekennzeichnet, dass** wenigstens einer der Polymeraktuatoren (15,16) als Stapelaktuator und/oder das wenigstens einer der Polymeraktuatoren als Rollenaktuator ausgebildet ist.

11. Verfahren zum Betreiben einer Einrichtung nach einem der Ansprüche 1 bis 7 oder eines Bremssystems nach einem der Ansprüche 8 bis 10, **dadurch gekennzeichnet, dass** die Polymeraktuatoren (15,16) unabhängig voneinander in Abhängigkeit eines gewünschten Pedalwiderstands angesteuert werden.

## Claims

1. Device for varying a pedal resistance of a hydraulic brake system (1), having at least one electroactive polymer actuator (15,16), **characterized by** a reaction disk (10) which has at least two polymer actuators (15,16) which can be actuated independently of one another and which are arranged coaxially to one another.

2. Device according to Claim 1, **characterized in that** the polymer actuators (15,16) are formed separately from one another.

3. Device according to either one of the preceding claims, **characterized in that** the polymer actuators (15,16) have at least one joint dielectric elastomer layer (17).

4. Device according to any one of the preceding claims, **characterized in that** at least one electrode (E15,E16) of the polymer actuators (15,16) protrudes laterally with respect to the electrical contact.

5. Device according to any one of the preceding claims, **characterized in that** the polymer actuators (15,16) are jointly housed, wherein the housing is formed to be deformable at least in regions.

6. Device according to any one of the preceding claims, **characterized in that** the housing is formed to be elastically deformable.

7. Device according to any one of the preceding claims, **characterized in that** the housing is manufactured from the material of the joint elastomer layer (17).

8. Brake system (1) for a vehicle, in particular motor vehicle, having a main brake cylinder (14), having a brake pedal (2) to displace a piston (13) in the main brake cylinder (14), having a brake booster (4) and having a device for varying a pedal resistance of the brake pedal (2), **characterized by** the formation of the device according to any one of Claims 1 to 7.

9. Brake system according to Claim 8, **characterized in that** the reaction disk (10) is connected/arranged between a brake piston (3) which is displaceable by the brake pedal (2) and a booster piston (8) which is displaceable by the brake booster (4) on one hand and the piston (13) of the main brake cylinder (14) on the other hand, wherein the inner polymer actuator (15) has a diameter smaller than or equal to the diameter of the brake piston (3).

10. Brake system according to any one of the preceding claims, **characterized in that** at least one of the polymer actuators (15,16) is formed as a stack actuator and/or that at least one of the polymer actuators is formed as a roller actuator.

11. Method for operating a device according to any one of Claims 1 to 7 or a brake system according to any one of Claims 8 to 10, **characterized in that** the polymer actuators (15,16) are actuated independently of one another as a function of a desired pedal resistance.

## Revendications

1. Dispositif destiné à varier une résistance de pédale d'un système de freinage hydraulique (1) doté d'au moins un actionneur polymère électroactif (15, 16), **caractérisé par** un disque de réaction (10), lequel comporte au moins deux actionneurs polymères (15, 16) commandables indépendamment l'un de l'autre, lesquels sont agencés de manière coaxiale l'un à l'autre.

2. Dispositif selon la revendication 1, **caractérisé en ce que** les actionneurs polymères (15, 16) sont conçus séparés l'un de l'autre.

3. Dispositif selon l'une des revendications précédentes, **caractérisé en ce que** les actionneurs polymères (15, 16) comportent au moins une couche d'élastomère diélectrique (17) commune.

4. Dispositif selon l'une des revendications précédentes, **caractérisé en ce qu'**au moins une électrode (E15, E16) des actionneurs polymères (15, 16) fait latéralement saillie pour un contact électrique.

5. Dispositif selon l'une des revendications précédentes, **caractérisé en ce que** les actionneurs polymères (15, 16) sont encoffrés ensemble, dans lequel le coffrage est conçu pour être déformable au moins par endroits.

6. Dispositif selon l'une des revendications précédentes, **caractérisé en ce que** le coffrage est conçu pour être élastiquement déformable.

7. Dispositif selon l'une des revendications précédentes, **caractérisé en ce que** le coffrage est fabriqué avec le matériau de la couche d'élastomère diélectrique (17) commune.

8. Système de freinage (1) pour un véhicule, en particulier un véhicule motorisé, doté d'un maître-cylindre de frein (14), doté d'une pédale de frein (2) pour le déplacement d'un piston (13) dans le maître-cylindre (14), doté d'un servofrein (4) et doté d'un dispositif destiné à varier une résistance de la pédale de frein (2), **caractérisé par** la conception du dispositif selon l'une des revendications 1 à 7.

9. Système de freinage selon la revendication 8, **caractérisé en ce que** le disque de réaction (10) est agencé/commuté entre un piston de freinage (3) pouvant coulisser sous l'effet de la pédale de frein (2) et un piston amplificateur (8) pouvant coulisser sous l'effet du servofrein (4) d'une part et le piston (13) du maître-cylindre de frein (14) d'autre part, dans lequel l'actionneur polymère interne (15) possède un diamètre inférieur ou égal au diamètre du piston de freinage (3) .

10. Système de freinage selon l'une des revendications précédentes, **caractérisé en ce qu'**au moins un des actionneurs polymères (15, 16) est conçu comme actionneur de type empilé et/ou **en ce que** l'au moins un des actionneurs polymères (15, 16) est conçu comme rouleau actionneur.

11. Procédé de fonctionnement d'un dispositif selon l'une des revendications 1 à 7 ou d'un système de freinage selon l'une des revendications 8 à 10, **caractérisé en ce que** les actionneurs polymères (15, 16) sont commandés indépendamment l'un de l'autre en fonction d'une résistance de pédale souhaitée.
